# EUROPÄISCHE PATENTSCHRIFT

(11) **EP 1 133 902 B1**
(45) Veröffentlichungstag und Bekanntmachung des Hinweises auf die Patenterteilung: **14.05.2003**
(21) Anmeldenummer: 99968773.4
(22) Anmeldetag: 03.11.1999
(51) Int. Cl.: H05K 1/03, H05K 3/00, B32B 27/08

(54) **ELEKTROMECHANISCHES BAUTEIL**
ELECTROMECHANICAL COMPONENT
COMPOSANT ELECTROMECANIQUE

(30) Priorität: 04.11.1998 DE 19850737; 15.01.1999 DE 19901262
(43) Veröffentlichungstag der Anmeldung: 19.09.2001
(73) Patentinhaber: DEUTSCHE THOMSON-BRANDT GMBH, 78048 Villingen-Schwenningen (DE)
(72) Erfinder: STRUBEL, Volker, D-97100 Freiburg (DE); HALLER, Hans-Otto, D-78078 Niedereschach (DE)
(74) Vertreter: Rossmanith, Manfred, Dr.
(86) Internationale Anmeldenummer: EP9908401
(87) Internationale Veröffentlichungsnummer: WO00027171

(56) Entgegenhaltungen:
- EP-A- 0 364 416
- WO-A-95/11129
- DE-A- 2 413 158
- DE-A- 3 805 120
- FR-A- 2 260 171
- FR-A- 2 455 616
- FR-A- 2 525 849
- US-A- 4 774 126
- W. SCHMIDT ET AL.: "Neue Dimensionen in der Leiterplattentechnik" FEINWERKTECHNIK + MESSTECHNIK., Bd. 102, Nr. 5/6, Mai 1994 (1994-05) - Juni 1994 (1994-06), Seiten 219-225, XP000449825 CARL HANSER VERLAG. MUNCHEN, DE.
- "Dreidimensionale Platinen aus "einem Guss"" ELEKTRONIK., Bd. 40, Nr. 12, 12. November 1991 (1991-11-12), Seiten 142-149, XP000267156 FRANZIS VERLAG GMBH. MUNCHEN., DE ISSN: 0013-5658

## Beschreibung

Die Erfindung betrifft ein elektromechanisches Bauteil insbesondere ein Bauteil nach dem Oberbegriff von Anspruch 1.

In der elektrotechnischen Industrie werden für zahlreiche Anwendungen Leiterplatten verwendet, die zum einen für die mechanische Halterung von elektronischen Komponenten sorgen und zum anderen gleichzeitig elektrische Verbindungen zwischen diesen Komponenten herstellen. Herkömmliche Leiterplatten sind häufig aus wärmegehärteten Materialien, wie z. B. Phenolharzpapier oder mit Glasfasern verstärkten Epoxydharz hergestellt. Diese Materialien sind als solche brennbar, was aus Sicherheitsgründen nicht akzeptabel ist. Daher werden diesen Materialien flammhemmende Chemikalien zugesetzt, wie z. B. Brom- oder organische Phosphorverbindungen, die im Zusammenwirken mit anderen anorganischen Substanzen, wie z. B. Antimontrioxyd als Synergist, die Entflammbarkeit der herkömmlichen Leiterplatten vermindern.

Die flammhemmenden Zusatzstoffe in den Leiterplatten bereiten jedoch erhebliche Schwierigkeiten bei der Wiederverwertung der Leiterplatten. Insbesondere die wärmehärtenden Materialien können nicht recycled werden und müssen daher in Deponien endgelagert werden. Weiterhin besteht die Möglichkeit, diese Materialien zu verbrennen, wobei erhebliche Anstrengungen nötig sind, um toxische Emissionen zu vermeiden, die von den flammhemmenden Chemikalien herrühren. Aus diesen Gründen sind die Kosten für die Beseitigung am Ende der Lebensdauer eines Produktes, das herkömmliche Leiterplatten enthält, relativ hoch. Mit Blick auf den allgemeinen Trend zu einer nachhaltigen Wirtschaftsweise ist es daher wünschenswert, Bauteile für elektrotechnische Anwendungen bereitzustellen, die am Ende der Lebensdauer eines Produktes mit wirtschaftlich vertretbaren Aufwand wiedergewinnbar sind.

Die DE 24 13 158 A beschreibt eine stanz- und bohrfähige feuerhemmende Isolierplatte für elektrotechnische Zwecke, die aus anorganischen Fasermaterial, anorganischen Bindemittel und anorganischen Füllstoff sowie einem wärmehärtbaren Harz hergestellt ist. Die anorganischen Materialien sind nicht brennbar, wohingegen das organische Harz brennbar ist. Bei dieser Isolierplatte handelt es sich um ein Mehrstoffsystem.

Hiervon ausgehend ist es Aufgabe der Erfindung ein Bauteil für elektrotechnische Anwendungen zu schaffen, das die eingangs beschriebenen Nachteile vermeidet.

Diese Aufgabe wird erfindungsgemäß durch ein Bauteil nach Anspruch 1 gelöst. Das Bauteil weist eine Tragschicht auf, wobei wenigstens die obere Seite der Tragschicht von einer Deckschicht bedeckt ist. Sowohl die Deckschicht als auch die Tragschicht sind aus demselben schwer brennbaren Kunststoffmaterial hergestellt. Die Deckschicht und die Tragschicht sind fest miteinander verbunden und verleihen dem Bauteil eine für die jeweilige Anwendung ausreichende mechanische Stabilität. Weiterhin trägt die Deckschicht elektrisch leitendes Material mittels dessen - gegebenenfalls nach einem weiteren Strukturierungsprozeß - elektrische Verbindungen zwischen elektronischen Komponenten herstellbar sind.

Der besondere Vorteil dieses Bauteils besteht darin, daß die flammhemmenden Eigenschaften ohne Zusatzstoffe erzielt werden, die am Ende der Lebensdauer eines Produktes Schwierigkeiten bei der Wiederverwertung bereiten.

Nach einem Ausführungsbeispiel der Erfindung kann die Deckschicht mehrlagig aus mehreren geschichteten Folien aufgebaut sein. Dieser Aufbau ist dann besonders vorteilhaft, wenn zwei oder mehr dieser Folien eine Leiterbahnstruktur tragen, wobei jede Ebene einer Leiterbahnstruktur von einer benachbarten Ebene räumlich durch eine elektrisch isolierende Folie beabstandet ist. Zwischen den Ebenen können im Bedarfsfall auch elektrische Verbindungen hergestellt werden.

Gemäß einem ersten Ausführungsbeispiel der Erfindung ist das elektrisch leitende Material als Schicht ausgebildet, welche die Deckschicht vollständig bedeckt. Beispielsweise kann diese Schicht aus einer dünnen Lage Kupfer bestehen, die in einem Ätzverfahren in Leiterbahnen strukturiert wird. Alternativ dazu können die Leiterbahnen auch in einem Heißprägeverfahren oder in einem selektiv chemisch galvanischen Verfahren hergestellt sein.

Es ist aber auch möglich, die Leiterbahnen aus einem fließfähigen Material in einem Druckverfahren hergestellt sind, insbesondere durch ein Siebdruckverfahren.

Besonders vorteilhaft ist es, wenn die Trag- und Deckschicht aus LCP-Kunststoffmaterial ("Liquid Crystal Plastic") oder Polyetherimid (PEI) hergestellt sind. Diese Materialien sind intrinsisch flammhemmend und einfach wiederzuverwerten.

Zweckmäßigerweise kann die Tragschicht aus geschäumten Kunststoffmaterial hergestellt sein. Das hat den Vorteil, daß das Bauteil als Ganzes leichter ist, wobei gleichzeitig eine ausreichende mechanische Stabilität erzielt wird. Darüber hinaus führt das Aufschäumen des Kunststoffes zu einer Materialersparnis, so daß die Kosten für das Bauteil vergleichbar sind mit den Kosten eines Teils, das aus herkömmlichen Material herstellt ist.

Besonders vorteilhaft ist es, wenn die Deckschicht biegsam ausgebildet ist, so daß das Bauteil z. B. bei der Montage in ein elektrisches Gerät verformbar ist. Die zur Montage von elektrischen Bauelementen erforderliche mechanische Stabilität kann dadurch erreicht werden, daß die flexible Deckschicht in den zur Aufnahme von Bauteilen bestimmten Bereichen mit einer Tragschicht verstärkt ist, während in den Bereichen, die flexibel bleiben sollen, die starre Tragschicht fehlt.

Nach einem Ausführungsbeispiel der Erfindung kann das Bauteil flach in Gestalt einer Leiterplatte ausgebildet sein. Es ist aber auch möglich, daß das Bauteil eine dreidimensionale Struktur aufweist und mit mechanischen Funktionselementen versehen ist. Diese mechanischen Funktionselemente können beispielsweise dazu dienen, schwere elektronische Komponenten, wie z. B. Kondensatoren oder Transformatoren, auf dem Bauteil zu haltern, ohne daß zusätzliche Befestigungselemente nötig sind. Weiterhin kann das Bauteil so ausgebildet sein, daß es zumindest bereichsweise den Zweck eines isolierenden Gehäuses für ein elektrisches Gerät erfüllt.

Eine weitere Aufgabe der Erfindung ist es, ein Verfahren anzugeben, wonach das erfindungsgemäße Bauteil in besonders günstiger Weise herstellbar ist.

Diese Aufgabe wird durch ein Verfahren nach Anspruch 14 gelöst.

In der Zeichnung sind Ausführungsbeispiele der Erfindung dargestellt, wobei für gleiche oder einander entsprechende Teile dieselben Bezugszeichen verwendet werden. Es zeigen:
- Fig. 1: ein als flache Platte ausgebildetes Bauteil nach der Erfindung;
- Fig. 2: einen Ausschnitt aus einem erfindungsgemäßen Bauteil, das eine kompliziertere räumliche Gestalt aufweist,
- Fig. 3: ein Anwendungsbeispiel eines erfindungsgemäßen Bauteiles, das mit mechanischen Funktionselementen versehen ist,
- Fig. 4a: ein Ausführungsbeispiel eines erfindungsgemäßen Bauteils, das sowohl starre als auch flexible Bereiche aufweist und
- Fig. 4b: einen Ausschnitt aus Fig. 4a.

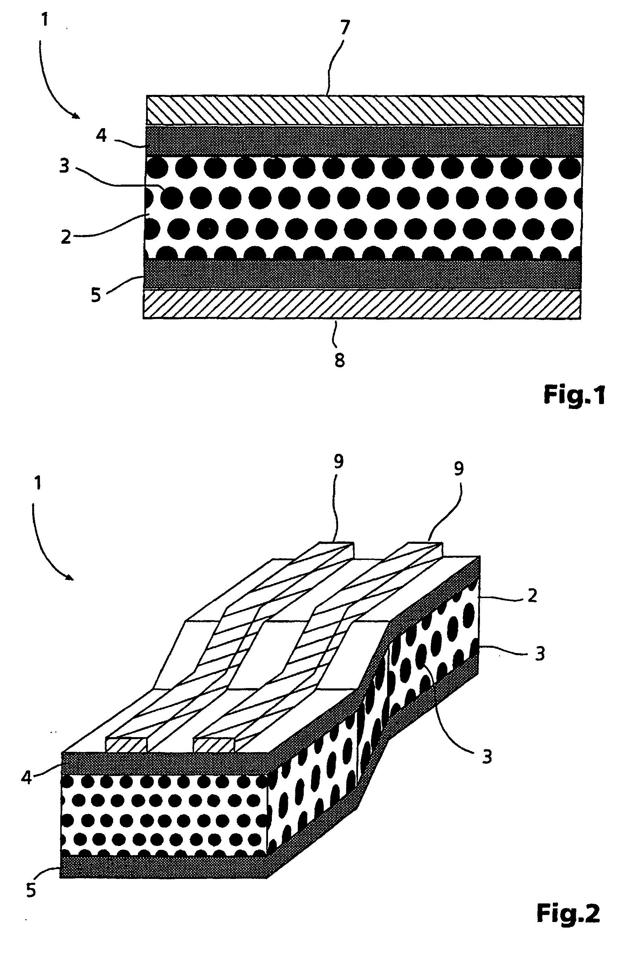

In Fig. 1 ist ein als ebene Platte ausgebildetes erfindungsgemäßes Bauteil 1 im Querschnitt dargestellt. Im Inneren des Bauteils 1 ist eine Tragschicht 2 angeordnet, die aus geschäumten LCP-Kunststoffmaterial hergestellt ist. Die geschäumte Tragschicht 2 enthält Gasblasen 3, so daß der Bedarf an relativ teurem LCP-Kunststoffmaterial erheblich reduziert ist, was sich günstig auf die Herstellungskosten und das Gewicht des Bauteiles 1 auswirkt. Mit der Tragschicht 2 ist eine obere Deckschicht 4 und eine untere Deckschicht 5 stoffschlüssig verbunden, die jeweils eine obere Kupferschicht 7 bzw. untere Kupferschicht 8 tragen. Die Kupferschichten sind ganzflächig ausgebildet, so daß diese z. B. durch photochemische Ätzverfahren für den jeweiligen Anwendungsfall unter Ausbildung von Leiterbahnen strukturierbar sind.

Es ist offensichtlich, daß das Bauteil auf der oberen Deckschicht 4 oder auf der unteren Deckschicht 5 oder auf beiden Deckschichten Leiterbahnen aufweisen kann. Demzufolge ist es auch möglich, das Bauteil 1 mit nur einer einzigen Kupferschicht herzustellen. Die mechanische Stabilität eines erfindungsgemäßen Bauteiles 1 entspricht ungefähr der von herkömmlichen Leiterplatten. Damit das Bauteil 1 z.B. herkömmliches FR4-Leiterplattenmaterial ersetzen kann, muß eine vorbestimmte Dicke eingehalten werden. Darüber hinaus sind jedoch durch geeignete Wahl der Abmessungen der Deckschicht(en) sowie der Tragschicht die mechanischen Eigenschaften des Bauteils an den jeweiligen Anwendungsfall anpaßbar. Es ist auch möglich, nur eine einzige Deckschicht 4 bzw. 5 vorzusehen.

Alternativ dazu ist es auch möglich, die Kupferschichten 7 und 8 in einem Heißprägeverfahren zu strukturieren. Weiterhin können die Leiterbahnstrukturen durch ein Siebdruckverfahren bspw. mit Silberleitpaste auf die Deckschicht aufzudruckt werden. Schließlich besteht auch die Möglichkeit, Leiterbahnen in einem selektiven chemisch galvanischen Verfahren abzuscheiden. Derartige Verfahren sind aus dem Stand der-Technik bekannt.

Weiterhin ist es möglich, das Bauteil 1 nicht nur plattenförmig zu gestalten, sondern diesem auch eine kompliziertere räumliche Struktur zu verleihen, wie dies in Fig. 2 veranschaulicht ist. Fig. 2 zeigt einen Ausschnitt aus einem Bauteil mit einer dreidimensionalen Struktur. Auf der oberen Deckschicht 4 sind bereits Leiterbahnen 9 strukturiert. Sowohl in Fig. 1 als auch in Fig. 2 ist deutlich zu erkennen, daß das erfindungsgemäße Bauteil eine Sandwich-Struktur aufweist.

Derartige Bauteile können an eine bestimmte Geräteform angepaßt sein und bereits mechanische Funktionselemente aufweisen. Diese Funktionselemente dienen z. B. zur Halterung von großen und schweren elektronischen Komponenten und übernehmen gleichzeitig die Funktion eines Gehäuses für das elektrische Gerät.

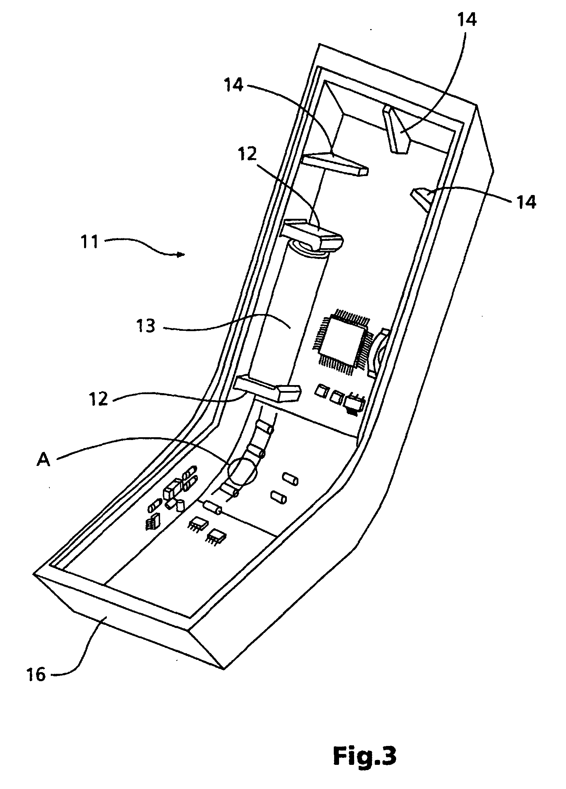

In Fig. 3 ist als Beispiel für ein solches Bauteil 1 ein Telefonhörer 11 für ein mobiles Telefon gezeigt. Ein mobiles Telefon benötigt relativ viel Elektronik im Hörer, die zum einen verschaltet und zum anderen mechanisch gehaltert werden muß. Bauteile, die diesen Zweck erfüllen, werden auch als MID-Bauteile ("Molded interconnect devices") bezeichnet. Bei dem dargestellten Telefonhörer 11 sind z. B. Halteclips 12 vorgesehen, um einen Akkumulator 13 sicher zu haltern. Weiterhin sind Versteifungsrippen 14 vorhanden, um dem Telefonhörer 11 eine ausreichende mechanische Stabilität zu verleihen. Darüber hinaus ist die Außenseite 16 des Telefonhörers 11 so gestaltet, daß ein für den Benutzer optisch und haptisch ansprechendes Äußeres erzielt wird. Es wird betont, daß alle diese Funktionen von einem einzigen Bauteil gleichzeitig erfüllt werden. Zur Veranschaulichung ist bei dem Bezugszeichen A die räumliche Lage des in Fig. 2 dargestellten Ausschnittes angedeutet.

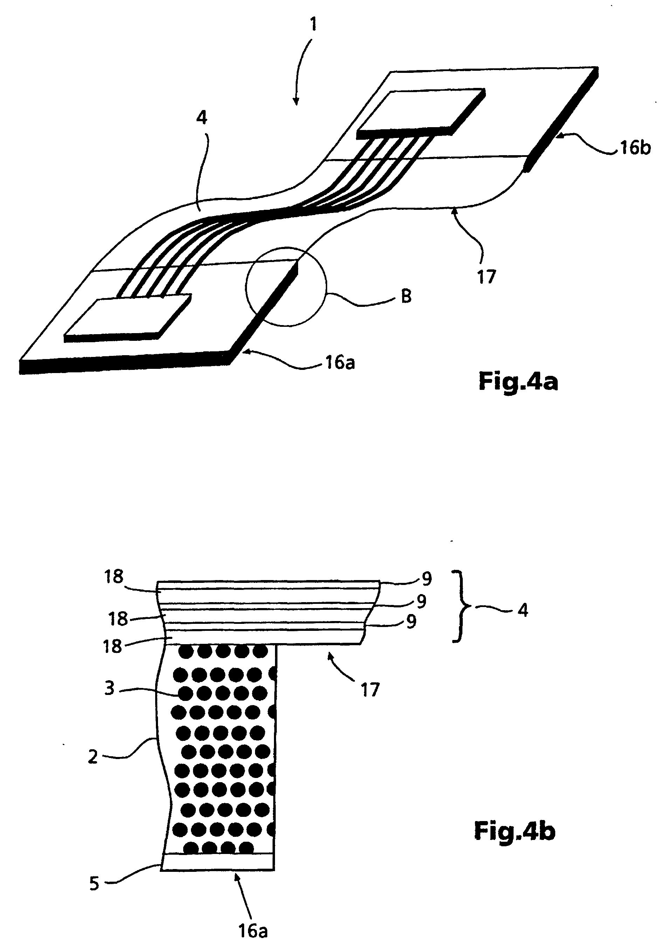

Schließlich ist es auch möglich, das erfindungsgemäße Bauteil so auszubilden, daß es beispielsweise zur Montage in einem Gerät gebogen werden kann. Fig. 4a zeigt ein Ausführungsbeispiel eines solchen Bauteiles, das zwischen zwei starren Bereichen 16a und 16b einen flexiblen Bereich 17 aufweist. Die starren Bereiche sind geeignet um beispielsweise elektronische Bauelemente zu haltern. Die elektronischen Bauelemente 18 können in herkömmlicher Weise aufgelötet oder aufgeklebt sein. Aber es ist auch möglich, daß Chips mit elektronischen Schaltungen direkt auf dem Bauteil 1 gebondet werden, wie es beispielsweise aus der Chip-On-Board-Technologie bekannt ist. Zwischen den elektronischen Bauteilen 18 stellen Leiterbahnen 9 elektrische Verbindungen her.

In Fig. 4b ist ein mit dem Bezugszeichen B bezeichneter Ausschnitt aus Fig. 4a gezeigt. In diesem Ausschnitt ist dargestellt, wie der Übergang zwischen dem starren Bereich 16a und dem flexiblen Bereich 17b entsteht. In dem starren Bereich 16a ist die Deckschicht 4 durch die Tragschicht 2 verstärkt, während in dem flexiblen Bereich keine Tragschicht 2 vorhanden ist. Die Deckschicht 4 ist flexibel, so daß das Bauteil 1 z. B. beim Einbau in ein Gerät entlang des Bereiches 17 gebogen werden kann. Die Tragschicht 2 ist auf der den Leiterbahnen 9 gegenüberliegenden Seite mit einer unteren Deckschicht 5 versehen, die jedoch auch weggelassen sein kann.

Bei dem in Fig. 4b dargestellten Ausführungsbeispiel ist die Deckschicht 4 aus übereinander geschichteten Folien 18 hergestellt, die jeweils Leiterbahnen 9 tragen, so daß auch mehrlagige Leiterplatten herstellbar sind. Abhängig davon ob sich die Tragschicht 2 über die gesamte Fläche der Deckschicht 4 erstreckt, ist es somit möglich sowohl starre als auch starr-flexible Bauteile mit mehreren Leiterebenen herzustellen.

Das in soweit beschriebene Bauteil wird folgendermaßen hergestellt:

Das Kunststoffmaterial wird in einem Spritz-Gußverfahren in eine Form gespritzt und in der Form expandiert, d. h. aufgeschäumt. Durch das Einhalten besonderer Temperaturbedingungen an der Gußformoberfläche kollabiert das aufgeschäumte Material in einem an die Gußform angrenzenden Bereich, wobei sich die Deckschichten 4 und 5 ausbilden, die keine Gasblasen 3 enthalten. Nach diesem Verfahren sind sowohl plattenförmige Bauteile als auch MID-Bauteile herstellbar. Abhängig von den Abmessungen der Gießform ist es mit diesem Verfahren auch möglich, die in den Fig. 4a und 4b gezeigte starr-flexible Leiterplatte herzustellen. Hierbei wird die Gußform so gewählt, daß in den Bereichen, die flexibel sein sollen, die Schichtdicke so gering gewählt ist, daß beim Spritzgießen eine LCP-Schicht ohne Gasblasen 3 entsteht, wohingegen in den starren Bereichen 16a und 16b das LCP-Material, wie oben beschrieben aufgeschäumt wird. Die dünne LCP-Schicht bildet den flexiblen Bereich 17 des Bauteils.

Es ist aber auch möglich, die Deckschicht 4 mit aufgeschäumten LCP-Material als Tragschicht 2 zu hinterkleben, um die starren Bereiche 17a und 17b herzustellen. Die nicht hinterklebten Bereiche der Deckschicht 4 bleiben dann flexibel.

Neben dem erwähnten LCP-Kunststoffmaterial können auch andere Hochtemperaturthermoplaste verwendet werden, die intrinsisch flammhemmend sind, z. B. Polyetherimid (PEI). Die vorgeschlagenen Kunststoffmaterialien sind intrinsisch flammhemmend nach der Norm UL94VO.

Ein besonderer Vorteil der auf diese Weise hergestellten Bauteile ist, daß sie aus einem einzigen sortenreinen Kunststoffmaterial bestehen und keine flammhemmenden Zusatzstoffe benötigen, so daß die Wiederverwertung dieser Bauteile in besonders einfacher Weise möglich ist.

Alle Ausführungsformen der Erfindung haben den Vorteil, daß sie herkömmliches Leiterplattenmaterial ersetzen können, ohne daß hierfür erprobte Herstellungs- und Verarbeitungsverfahren geändert werden müssen. Bei den Bauteilen mit einer aufgeschäumten Tragschicht ist diesbezüglich einschränkend zu bemerken, daß die Gasblasen 3 in der Tragschicht 2 nur so groß sein dürfen, daß noch eine sichere Verbindung durch ein Durchkontaktierungsloch herstellbar ist.

## Patentansprüche

1. Elektromechanisches Bauteil, das mindestens eine Tragschicht mit einer Oberseite und einer Unterseite aufweist, wobei wenigstens eine dieser Seiten von einer Deckschicht bedeckt ist, die mit der Tragschicht fest verbunden ist und die elektrisch leitendes Material trägt, **dadurch gekennzeichnet, daß** die Deckschicht (4, 5) und die Tragschicht (2) aus demselben schwer brennbaren Kunststoffmaterial hergestellt sind.

2. Bauteil nach Anspruch 1, **dadurch gekennzeichnet, daß** die Deckschicht (4, 5) mehrlagig aus mehreren geschichteten Folien (18) aufgebaut ist.

3. Bauteil nach Anspruch 2, **dadurch gekennzeichnet, daß** wenigstens zwei der Folien (18) elektrisch leitendes Material tragen, wobei die Folien (18) so angeordnet sind, daß das elektrisch leitende Material in mehreren Ebenen angeordnet ist, wobei die Folien als elektrischer Isolator zwischen dem elektrisch leitenden Material liegen.

4. Bauteil nach Anspruch 1, **dadurch gekennzeichnet, daß** das elektrisch leitende Material als Schicht (7, 8) auf der Deckschicht (4, 5) ausgebildet ist.

5. Bauteil nach Anspruch 1 oder 3, **dadurch gekennzeichnet, daß** das elektrisch leitende Material in Gestalt von Leiterbahnen (9) strukturiert ist.

6. Bauteil nach Anspruch 1, **dadurch gekennzeichnet, daß** als schwer brennbarer Kunststoff LCP-Kunststoffmaterial oder Polyetherimid (PEI) verwendet ist.

7. Bauteil nach Anspruch 1, **dadurch gekennzeichnet, daß** die Tragschicht (2) aus geschäumten Kunststoffmaterial hergestellt ist.

8. Bauteil nach Anspruch 1, **dadurch gekennzeichnet, daß** die Deckschicht (4, 5) mit der Tragschicht (2) stoffschlüssig verbunden ist.

9. Bauteil nach Anspruch 1, **dadurch gekennzeichnet, daß** die eine Deckschicht (4) biegsam ausgebildet ist.

10. Bauteil nach Anspruch 9, **dadurch gekennzeichnet, daß** die Fläche der Tragschicht (2) kleiner ist als die Fläche der einen Deckschicht (4).

11. Bauteil nach Anspruch 1, **dadurch gekennzeichnet, daß** das Bauteil sowohl eine obere Deckschicht (4) als auch eine untere Deckschicht (5) aufweist.

12. Bauteil nach Anspruch 1, **dadurch gekennzeichnet, daß** das Bauteil in Gestalt einer Leiterplatte flach ausgebildet ist.

13. Bauteil nach Anspruch 1, **dadurch gekennzeichnet, daß** das Bauteil eine dreidimensionale Struktur aufweist und mit mechanischen Funktionselementen (12, 14) versehen ist.

14. Verfahren zur Herstellung eines Bauteils nach einem der vorstehenden Ansprüchen, wobei zunächst Kunststoffmaterial in eine Gußform eingespritzt wird und anschließend das Kunststoffmaterial in der Gußform in der Weise expandiert wird, daß ein aufgeschäumtes Kunststoffmaterial entsteht und ein Bauteil bildet, bei dem das aufgeschäumte Material bis zu einer bestimmten Tiefe unter der Oberfläche des Bauteils kollabiert, so daß dieser Bereich des Bauteils keine Gasblasen enthält.

## Claims

1. Electromechanical component which has at least one support layer with a top side and an underside, at least one of these sides being covered by a covering layer which is permanently connected to the support layer and which bears electrically conducting material, **characterized in that** the covering layer (4, 5) and the support layer (2) are produced from identical relatively non-combustible plastic material.

2. Component according to claim 1, **characterized in that** the covering layer (4, 5) is constructed in a multi layer fashion from a plurality of layered films (18).

3. Component according to claim 2, **characterized in that** at least two of the films (18) bear electrically conducting material, the films (18) being arranged such that the electrically conducting material is arranged in a plurality of planes, the films being situated as an electric insulator between the electrically conducting material.

4. Component according to claim 1, **characterized in that** the electrically conducting material is formed as a layer (7, 8) on the covering layer (4, 5).

5. Component according to claim 1 or 3, **characterized in that** the electrically conducting material is structured in the form of conductor tracks (9).

6. Component according to claim 1, **characterized in that** LCP-plastic material or polyetherimide (PEI) is used as a relatively non-cumbustible plastic.

7. Component according to claim 1, **characterized in that** the support layer (2) is produced from foamed plastic material.

8. Component according to claim 1, **characterized in that** the covering layer (4,5) is connected to the support layer (2) by adhesive bonding.

9. Component according to claim 1, **characterized in that** the one covering layer (4) is of flexible design.

10. Component according to claim 9, **characterized in that** the surface area of the support layer (2) is smaller than the surface area of the one covering layer (4).

11. Component according to claim 1, **characterized in that** the component has both an upper covering layer (4) and a lower covering layer (5).

12. Component according to claim 1, **characterized in that** the component is of flat design in the form of a printed circuit board.

13. Component according to claim 1, **characterized in that** the component has a three dimensional structure and is provided with mechanical functional elements (12, 13).

14. Method for producing a component according to one of the preceding claims, in which firstly plastic material is injected into a mould and the plastic material in the mould is subsequently expanded in such a way that a foamed plastic material is produced forming a component wherein the foamed material collapses adjacent to the mould surface forming the covering layers containing no gas bubbles.

## Revendications

1. Composant électronique qui possède au moins une couche-support avec une face supérieure et une face inférieure, l'une de ces faces au moins étant recouverte par une couche de recouvrement, laquelle est fixement assemblée avec la couche-support et supporte le matériau conducteur électrique, **caractérisé en ce que** la couche de recouvrement (4, 5) et la couche-support (2) sont fabriquées à partir du même matériau synthétique difficilement inflammable.

2. Composant selon la revendication 1, **caractérisé en ce que** la couche de recouvrement (4, 5) multicouche est constituée à partir de plusieurs feuilles (18) stratifiées.

3. Composant selon la revendication 2, **caractérisé en ce qu'**au moins deux des feuilles (18) supportent un matériau conducteur électrique, les feuilles (18) étant positionnées de telle façon que le matériau conducteur électrique est ordonné sur plusieurs niveaux, les feuilles étant positionnées en tant qu'isolateur électrique entre le matériau conducteur électrique.

4. Composant selon la revendication 1, **caractérisé en ce que** le matériau conducteur électrique est structuré en couche (7, 8) sur la couche de recouvrement (4, 5).

5. Composant selon la revendication 1 ou 3, **caractérisé en ce que** le matériau conducteur électrique est structuré sous forme de pistes conductives (9).

6. Composant selon la revendication 1, **caractérisé en ce que** du matériau synthétique LCP ou polyétherimide (PEI) est utilisé comme matériau difficilement inflammable.

7. Composant selon la revendication 1, **caractérisé en ce que** la couche-support (2) est fabriquée à partir d'un matériau synthétique moussé.

8. Composant selon la revendication 1, **caractérisé en ce que** la couche de recouvrement (4, 5) est assemblée avec la couche-support (2) de façon permanente.

9. Composant selon la revendication 1, **caractérisé en ce que** ladite couche de recouvrement (4) est structurée de façon à pouvoir être courbé.

10. Composant selon la revendication 9, **caractérisé en ce que** la surface de la couche-support (2) est plus petite que la surface de ladite couche de recouvrement (4).

11. Composant selon la revendication 1, **caractérisé en ce que** le composant possède aussi bien une couche de recouvrement supérieure (4) qu'une couche de recouvrement inférieure (5).

12. Composant selon la revendication 1, **caractérisé en ce que** le composant est structuré sous la forme d'un circuit imprimé plat.

13. Composant selon la revendication 1, **caractérisé en ce que** le composant possède une structure tridimensionnelle et possède des éléments opérationnels mécaniques (12, 14).

14. Procédé de fabrication d'un composant selon l'une des revendications précédentes, le matériau synthétique étant d'abord injecté dans un moule et ensuite ledit matériau synthétique étant expansé dans le moule de façon à produire un matériau synthétique moussé et former un composant, pour lequel le matériau moussé retombe jusqu'à une certaine profondeur au dessous de la surface du composant, de façon à ce que la zone du composant ne contienne pas de bulles.
